# EUROPEAN PATENT APPLICATION

(11) **EP 1 724 744 A1**
(43) Date of publication of application: **22.11.2006**
(21) Application number: 06010112.8
(22) Date of filing: 16.05.2006
(51) Int. Cl.: G09G 3/00

(54) **Test probe and manufacturing method for test probe**

(30) Priority: 20.05.2005 JP 2005147822
(71) Applicant: SEIKO EPSON CORPORATION, Shinjuku-ku, Tokyo 163-0811 (JP)
(72) Inventor: Ito, Haruki, Suwa-shi Nagano-ken (JP)
(74) Representative: HOFFMANN EITLE

(57) **Abstract**

A test probe for testing a semiconductor device (100), includes: a substrate (2) having a first surface (2a) and a second surface (2b); an input projection portion (11) formed on the first surface (2a); an output projection portion (21) formed on the first surface (2a); input contacting portions (13), each of which is in contact with each of the input terminals (101) and is formed on the input projection portion (11); output contacting portions (23), each of which is in contact with each of the output terminals (102) and is formed on the output projection portion (21); input conductive portions (14) formed on the first surface (2a), each of which is electrically connected to each of the input contacting portions (13); and output conductive portions (24) formed on the first surface (2a), each of which is electrically connected to each of the output contacting portions (23).

## Description

### CROSS-REFERENCE TO RELATED APPLICATION

This application claims priority to Japanese Patent Application No. 2005-147822, filed May 20, 2005, the contents of which are incorporated herein by reference.

### BACKGROUND

### 1. Technical Field

The present invention relates to test probe and manufacturing method for a test probe.

### 2. Related Art

When a plurality of IC chips are formed on a semiconductor wafer in a semiconductor process, the electrical characteristics of each IC chip with the semiconductor wafer in its original form (without cutting the semiconductor wafer) are tested and defective items are screened.

Ordinary probing devices are used for such testing, as disclosed in Japanese Unexamined Patent Application, First Publication No. 2001-289874 and Japanese Unexamined Patent Application, First Publication No. 2004-294063.

General-purpose probing devices are used for electrical tests such as continuity test of each IC chip by bringing the probe needles of the probe card in contact with the electrode terminal in each IC chip on the semiconductor wafer and by applying a predetermined voltage through the probe needle.

The probe disclosed in Japanese Unexamined Patent Application, First Publication No. 2001-289874 has a plurality of probe needles consisting of tungsten or rhenium tungsten.

The probe disclosed in Japanese Unexamined Patent Application, First Publication No. 2004-294063 has a plurality of probe needles consisting of alloys of nickel, beryllium, copper, and titanium.

However, the above-described the prior art has the following problems.

With the increase in demand for finer wirings of semiconductor devices in recent years, the pitch of input terminals and the pitch of output terminals of semiconductor devices are finer (more narrow) than before.

Consequently, the pitch of the probe needles in the probe card also needs to be made finer (more narrow).

However, it is difficult to reduce the pitch of the probe needles in the plurality of probe needles of the prior art mentioned above.

### SUMMARY

An advantage of some aspects of the invention is to provide a test probe and manufacturing method for a test probe, for satisfactorily testing semiconductor devices while capably corresponding to the fine pitch, even if the pitch of input terminals and the pitch of output terminals of semiconductor device are fine.

A first aspect of the invention provides a test probe for testing a semiconductor device having a plurality of input terminals and a plurality of output terminals, including: a substrate having a first surface and a second surface; an input projection portion, made of resin, formed on the first surface of the substrate, and corresponding to an array of the input terminals of the semiconductor device; an output projection portion, made of resin, formed on the first surface of the substrate, and corresponding to an array of the output terminals of the semiconductor device; a plurality of input contacting portions, each of which is in contact with each of the input terminals of the semiconductor device and is formed on the input projection portion; a plurality of output contacting portions, each of which is in contact with each of the output terminals of the semiconductor device and is formed on the output projection portion; a plurality of input conductive portions formed in an area other than an area on which the input projection portion is formed on the first surface of the substrate, each of which is electrically connected to each of the input contacting portions; and a plurality of output conductive portions formed in an area other than an area on which the output projection portion is formed on the first surface of the substrate, each of which is electrically connected to each of the output contacting portions.

Since input contacting portions is formed on the input projection portion, output contacting portions is formed on the input projection portion, input conductive portions and output conductive portions are formed on the substrate in the test probe of the first aspect of the invention, very fine contacting portions and conductive portions can be obtained by the application of semiconductor device manufacturing technologies.

Accordingly, a test probe provided with very fine contacting portions and conductive portions can be realized by corresponding to the fine pitch, especially, a pitch of the output terminals of the semiconductor device.

It is preferable that, in the test probe of the first aspect of the invention, semiconductor devices including the input terminals provided on the side of one edge and the output terminals provided on the side of the other edge be tested.

When the input contacting portions are in contact with the input terminals of the semiconductor device and the output contacting portions in contact with the output terminals of the semiconductor device, it is possible to obtain that input contacting portions are firm contact with the input terminals of the semiconductor device, and output contacting portions are firm contact with the output terminals of the semiconductor device, by an elastic action of the input projection portion and the output projection portion.

The input projection portion and the output projection portion are made of resin and positioned as the base of the input contacting portions and the output contacting portions.

Accordingly, satisfactory tests of semiconductor devices can be performed by a test probe provided with input projection portion and output projection portion.

Moreover, by providing input conductive portions and output conductive portions, the input of signals such as test signals from the input conductive portions to the input terminals of the semiconductor device is facilitated, and the extraction of signals such as test signals by the output conductive portions from the output terminals is also facilitated.

It is preferable that, in the test probe of the first aspect of the invention, the input contacting portions be formed side by side, corresponding to a direction of the array of the input terminals of the semiconductor device, the output contacting portions be formed side by side, corresponding to a direction of the array of the output terminals of the semiconductor device, each of the input conductive portions be formed to correspond to each of the input contacting portions, and each of the output conductive portions be formed to correspond to each of the output contacting portions.

Since the test probe includes the input contacting portions formed to correspond to the direction of array of the plurality of input terminals of semiconductor device, the output contacting portions formed to correspond to the direction of array of the plurality of output terminals of semiconductor device, by bringing each of the input contacting portions in contact with each of the input terminals of the semiconductor device, and by bringing each of the output contacting portions in contact with each of the output terminals of the semiconductor device, the semiconductor device can be satisfactorily tested.

Furthermore, since the input conductive portions are formed on the substrate to correspond to the input contacting portions, and the output conductive portions are formed to correspond to the output contacting portions, the input of signals such as test signals from the input conductive portions and the output conductive portions to the semiconductor device, and the extraction of test signals from the semiconductor device are facilitated.

It is preferable that, in the test probe of the first aspect of the invention, the input projection portion extend in the direction of an array of the input contacting portions, and the output projection portion extend in the direction of an array of the output contacting portions.

Since the test probe includes the input projection portion extending in the direction of the array of the input contacting portions and includes the output projection portion extending in the direction of the array of the output contacting portions, the input contacting portions can be formed on the same projection portion, and the output contacting portions can be formed on the same projection portion.

Accordingly, the heights of each of the input contacting portions from the substrate can be generally uniform, and the heights of each of the plurality of output contacting portions from the substrate can be generally uniform.

As a result, each of the input contacting portions can be brought into firm contact with each of the plurality of input terminals of the semiconductor device, and each of the output contacting portions can be brought into firm contact with each of the plurality of output terminals of the semiconductor device.

It is preferable that, in the test probe of the first aspect of the invention, a cross-section of the input projection portion viewed from the direction of the array of the input contacting portions be in the shape of a circular arc projecting from the first surface of the substrate, and a cross-section of the output projection portion viewed from the direction of the array of the output contacting portions be in the shape of a circular arc projecting from the first surface of the substrate.

Since the test probe includes each of the input contacting portions formed on the surface of the input projection portion having the shape of a circular arc in the cross sectional view, and includes each of the output contacting portions formed on the surface of the output projection portion having the shape of a circular arc in the cross sectional view, each of the input contacting portions can be brought into satisfactory contact with each of the input terminals of the semiconductor device, and each of the output contacting portions can be brought into satisfactory contact with each of the output terminals of the semiconductor device.

Since the surface of the input projection portion has the shape of circular arc in the cross-sectional view, each of the input contacting portions when formed on the surface of the input projection portion can be brought into close and satisfactory contact with the input terminals.

Since the surface of the output projection portion has the shape of circular arc in the cross-sectional view, each of the input contacting portions when formed on the surface of the output projection portion can be brought into close and satisfactory contact with the output terminals.

It is preferable that the test probe of the first aspect of the invention further include: a plurality of depressions formed on the surface of the input projection portion and on the surface of the output projection portion, each of which be formed in an area other than an area on which each of the input contacting portions, and in an area other than an area on which each of the output contacting portions is formed.

Since the test probe has depressions each of which formed in an area on the surface of the input projection portion other than an area on which each of the input contacting portions is formed, that is, since a depression is formed in the area between each of the input contacting portion, when each of the input contacting portions is in contact with each of the input terminals of the semiconductor device, the input projection portion forming the base of the input contacting portions, is likely to deflect and deform easily.

Since the test probe has depressions each of which formed in an area on the surface of the output projection portion other than an area on which each of the output contacting portions is formed, that is, since a depression is formed in the area between each of the output contacting portion, when each of the output contacting portions is in contact with each of the output terminals of the semiconductor device, the output projection portion forming the base of the output contacting portions, is likely to deflect and deform easily.

Accordingly, because of this deflection and deformation, satisfactory contact of the input contacting portions with the input terminals of the semiconductor device can be obtained, and satisfactory contact of the output contacting portions with the output terminals of the semiconductor device can be obtained.

Moreover, short-circuitting between the input contacting portions adjacent to each other, or short-circuitting between the output contacting portions adjacent to each other can be prevented.

It is preferable that the test probe of the first aspect of the invention further include: a plurality of input continuity portions, each of which passes through the substrate from the first surface to the second surface and be electrically connected to each of the input conductive portions; a plurality of output continuity portions, each of which passes through the substrate from the first surface to the second surface and be electrically connected to each of the output conductive portions; a plurality of input connecting conductive portions, each of which be electrically connected to each of the input continuity portions and be formed on the second surface of the substrate; and a plurality of output connecting conductive portions, each of which be electrically connected to each of the output continuity portions and be formed on the second surface of the substrate.

In the test probe, each of the input contacting portions is electrically connected to each of the input connecting conductive portions formed on the second surface of the substrate via each of the input continuity portions.

Furthermore, each of the output contacting portions is electrically connected to each of the output connecting conductive portions formed on the second surface of the substrate via each of the plurality of output continuity portions.

Accordingly, when testing a semiconductor device by facing the input projection portion to the input terminals of the semiconductor device, signals such as test signals can be input to the input terminals of the semiconductor device via the input connecting conductive portions from a surface (second surface) other than the surface (first surface) facing the input terminals of the semiconductor device.

Furthermore, when testing a semiconductor device by facing the output projection portion to the output terminals of the semiconductor device, signals such as test signals can be extracted from the output terminals of the semiconductor device via the output connecting conductive portions from a surface (second surface) other than the surface (first surface) facing the output terminals of the semiconductor device.

Moreover, compared to the case of which the input connecting conductive portions and the output connecting conductive portions are formed on the first surface of the substrate, the input and the extraction of signals such as test signals are facilitated, and semiconductor devices can be easily tested.

The work of installing the test probe on the testing unit also becomes easier.

It is preferable that, in the test probe of the first aspect of the invention, a spacing between each of the adjacent input connecting conductive portions be larger than a spacing between each of the adjacent input conductive portions, and a spacing between each of the adjacent output connecting conductive portions be larger than a spacing between each of the adjacent output conductive portions.

Since the test probe includes the spacing between each of the adjacent plurality of input connecting conductive portions that is formed larger than the spacing between each of the adjacent plurality of input conductive portions formed on the first surface of the substrate, when testing a semiconductor device, short-circuitting of signals such as test signals between adjacent input conductive portions can be prevented, and as a result, testing can be performed correctly.

Moreover, since the test probe includes the spacing between each of the adjacent plurality of output connecting conductive portions that is formed larger than the spacing between each of the adjacent plurality of output conductive portions formed on the first surface of the substrate, when testing a semiconductor device, short-circuitting of signals such as test signals between adjacent output conductive portions can be prevented, and as a result, testing can be performed correctly.

Accordingly, the input conductive portions and the output conductive portions of fine pitch can be formed.

It is preferable that the test probe of the first aspect of the invention further include: an insulating layer covering the input conductive portions and the output conductive portions.

By forming an insulating layer covering the input conductive portions and the output conductive portions in the test probe of the first aspect of the invention, short-circuitting between the input conductive portions and the semiconductor device, or short-circuitting between the output conductive portions and the semiconductor device can be prevented.

Furthermore, short-circuitting between each of the input continuity portions or short-circuitting between each of the output continuity portions can be prevented.

A second aspect of the invention provides a manufacturing method for a test probe testing semiconductor device having a plurality of input terminals and a plurality of output terminals, including: preparing the substrate; forming input projection portion made of resin on the substrate and corresponding to an array of the input terminals of the semiconductor device; forming output projection portion made of resin on the substrate and corresponding to an array of the output terminals of the semiconductor device; forming a plurality of input contacting portions on the input projection portion; forming a plurality of output contacting portions on the output projection portion; forming on the substrate a plurality of input conductive portions in an area other than an area on which the input projection portion is formed; and forming on the substrate a plurality of output conductive portions in an area other than an area on which the output projection portion is formed.

Since the manufacturing method for the test probe of the second aspect of the invention includes the formation of the input contacting portions and the output contacting portions after the formation of input projection portion and output projection portion on the substrate, very fine contacting portions and conductive portions can be obtained by the application of semiconductor device manufacturing technologies.

Accordingly, a test probe provided with very fine contacting portions and conductive portions can be realized by corresponding to the fine pitch, especially of the output terminals of the semiconductor device.

Moreover, when the input contacting portions and the output contacting portions are in contact with the input terminals and output terminals respectively of the semiconductor device, by the elastic action of the input projection portion and the output projection portion that are made of resin and arranged as the base of the input contacting portions and the output contacting portions, firm contact of the input terminals and the output terminals can be obtained.

Accordingly, satisfactory tests of semiconductor devices can be performed by a test probe provided with input projection portion and output projection portion.

It is preferable that the manufacturing method for a test probe of the second aspect of the invention further include: forming a plurality of depressions, each of which is formed in an area other than an area on which each of the input contacting portions is formed on the surface of the input projection portion by half-etching; and forming a plurality of depressions, each of which is formed in an area other than an area on which each of the output contacting portions is formed on the surface of the output projection portion by half-etching. The input contacting portions are formed side by side to correspond to the direction of the array of the input terminals of the semiconductor device, the output contacting portions are formed side by side to correspond to the direction of the array of the output terminals of the semiconductor device.

Since the manufacturing method for the test probe of the second aspect of the invention includes the formation of depressions in areas on the surface of the input projection portion other than areas on which the input contacting portions are formed, that is, since a depression is formed in the area between each of the input contacting portions, when each of the input contacting portions is in contact with each of the input terminals of the semiconductor device, the input projection portion forming the base of the input contacting portions, is likely to deflect and deform easily.

Since the manufacturing method for the test probe of the second aspect of the invention includes the formation of depressions in areas on the surface of the output projection portion other than areas on which the output contacting portions are formed, that is, since a depression is formed in the area between each of the output contacting portions, when each of the plurality of output contacting portions is in contact with each of the output terminals of the semiconductor device, the output projection portion forming the base of the output contacting portions, is likely to deflect and deform easily.

Accordingly, because of this deflection and deformation, satisfactory contact of the input contacting portions with the input terminals of the semiconductor device can be obtained, and satisfactory contact of the output contacting portions with the output terminals of the semiconductor device can be obtained.

Moreover, short-circuitting between the input contacting portions adjacent to each other, or short-circuitting between the output contacting portions adjacent to each other can be prevented.

Also, depressions with the desired depth can be formed by adjusting the etching time.

Accordingly, by a simple method, depressions can be formed in the input projection portion and the output projection portion, and satisfactory contact can be obtained between the input contacting portions and the output contacting portions with the input terminals and the output terminals of the semiconductor device.

It is preferable that, in the manufacturing method for a test probe of the second aspect of the invention, the input projection portion and the output projection portion be made of photosensitive resin.

In the manufacturing method for the test probe of the second aspect of the invention, using of photosensitive resin and a method such as the photolithographic method, it is possible to form the input projection portion and the output projection portion highly precision.

By changing the exposure conditions, developing conditions, or curing conditions, the input projection portion and the output projection portion of the desired shape made of resin can be obtained.

It is preferable that, in the manufacturing method for a test probe of the second aspect of the invention, the input projection portion and the output projection portion be formed on the substrate by ejecting functional liquid including resinous material on the substrate by a liquid ejection method.

In the manufacturing method for the test probe of the second aspect of the invention, by using the liquid ejection method, it is possible to accurately eject the functional liquid including resin.

Thus, the input projection portion and the output projection portion of the desired shape can be obtained.

Accordingly, the manufacturing cost can be reduced because no wastage of material occurs.

It is preferable that, in the manufacturing method for a test probe of the second aspect of the invention, the input contacting portions, the input conductive portions, the output contacting portions, and the output conductive portions, be formed by a sputtering method or a plating method.

In the manufacturing method for the test probe of the second aspect of the invention, by using the sputtering method or the plating method, it is possible to form the input contacting portions, the input conductive portions, the output contacting portions, and the output conductive portions at the predetermined positions on the substrate at a fine pitch highly precision.

It is preferable that, in the manufacturing method for a test probe of the second aspect of the invention, the input contacting portions, the input conductive portions, the output contacting portions, and the output conductive portions, be formed on the substrate by a liquid ejection method.

The manufacturing method for the test probe of the second aspect of the invention, by using the liquid ejection method, it is possible to form the input contacting portions, the input conductive portions, the output contacting portions, and the output conductive portions at the predetermined positions inhibiting the wastage of materials.

It is possible to reduce the manufacturing cost.

It is preferable that the manufacturing method for a test probe of the second aspect of the invention further include: preparing a base substrate; forming a plurality of probe formation areas, each of which corresponds to each of the test probes on the base substrate; cutting the base substrate at each the probe formation areas; and obtaining a plurality of individual test probes.

In the manufacturing method for the test probe of the second aspect of the invention, by forming the probe formation areas on the base substrate simultaneously, then cutting the base substrate at each of the probe formation areas, it is possible to obtain a plurality of individual test probes.

Accordingly, the test probes can be manufactured efficiently, and reduction in manufacturing cost of the test probe can be realized.

### BRIEF DESCRIPTION OF THE DRAWINGS

FIG. 1 is a perspective view of a semiconductor wafer and the test probe of the invention.

FIG. 2 is a perspective view of the test probe of the first embodiment of the invention.

FIG. 3 is a cross-sectional view of the test probe of viewed from the Y direction in FIG. 2.

FIG. 4 is a cross-sectional view of the test probe, taken along line A-A in FIG. 3.

FIGS. 5A to 5C are a cross-sectional views of the silicon wafer for explaining an example of a manufacturing process for the test probe.

FIGS. 6A to 6D are a cross-sectional views of the silicon wafer for explaining an example of a manufacturing process for the test probe.

FIG. 7 is a plan view of an input conductive portion and an output conductive portion of the test probe of the second embodiment of the invention.

FIG. 8 is a cross-sectional view of an example of a semiconductor device subject to tests.

### DESCRIPTION OF EXEMPLARY EMBODIMENTS

The exemplary embodiments of the invention are described below referring to the drawings.

In the explanations below, XYZ orthogonal coordinate system is set, and the positional relationships of various members are described with reference to this XYZ orthogonal coordinate system.

A predetermined direction in the plan view is taken as the X-axis direction, a direction perpendicular to the X-axis direction in the plan view is taken as the Y-axis direction, and a direction perpendicular both the X-axis direction and the Y-axis direction (that is vertical direction), is taken as the Z-axis direction.

First embodiment of the test probe

The first embodiment of test probe 1 is explained here referring to the drawings.

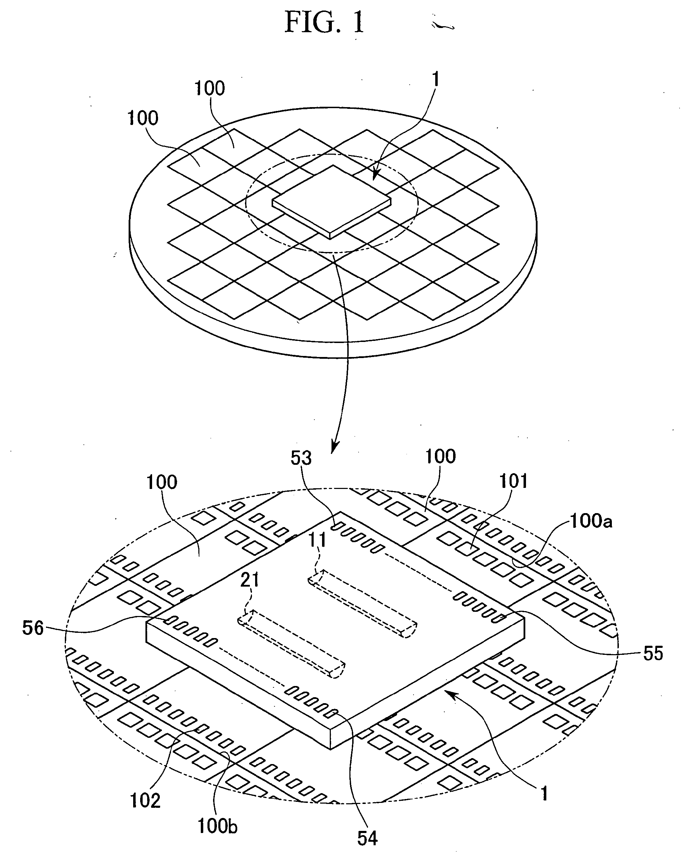

FIG. 1 is a perspective view of semiconductor device 100 tested by the test probe of the first embodiment of the invention and also shows the condition of a plurality of semiconductor devices 100 formed on semiconductor wafer being tested by the test probe.

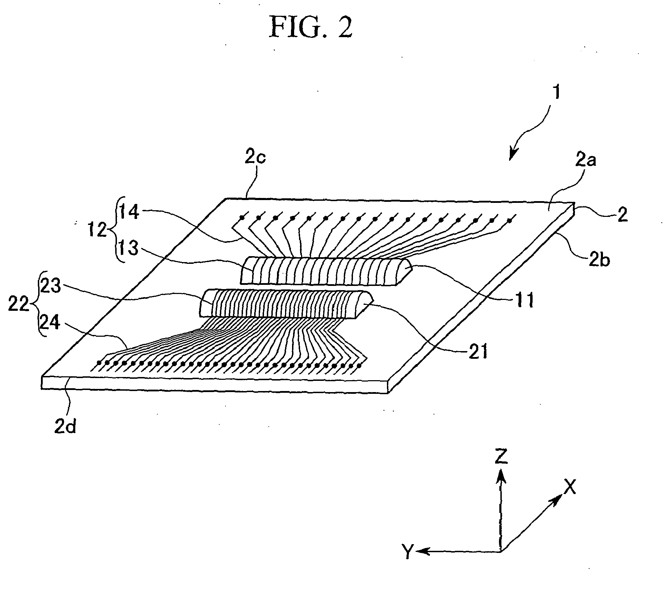

FIG. 2 is a perspective view of the test probe 1 of the first embodiment of the invention.

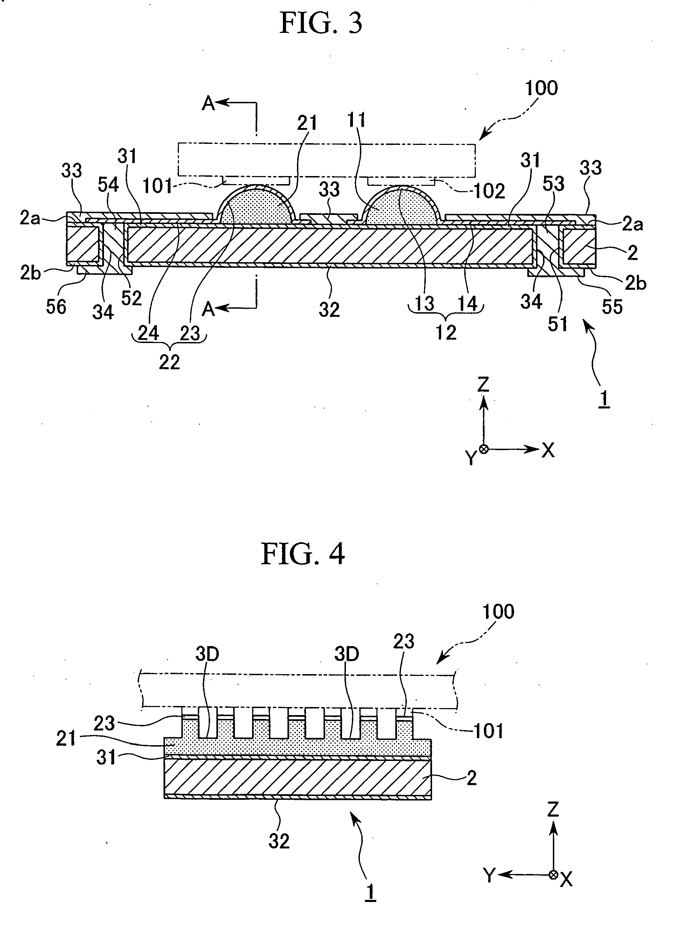

FIG. 3 is a cross-sectional view of the test probe 1 when viewed from the direction of the Y-axis.

FIG. 4 is a cross-sectional view of the test probe 1 when viewed from the direction of the X-axis.

The test probe 1 tests the semiconductor device 100 having a plurality of input terminals 101 and a plurality of output terminals 102.

The test probe 1 tests characteristics, such as short-circuitting or breaks in the semiconductor device 100 by input of test signal or the similar to the semiconductor device 100 via the input terminals 101 and by extraction of test signal or the similar from the output terminals 102 of semiconductor device 100.

As shown in FIG. 1, a plurality of semiconductor devices 100 formed in an array on a semiconductor wafer as probe formation areas.

Also, the plurality of semiconductor devices 100 are separated by boundary lines 100a and 100b on the semiconductor wafer.

The input terminals 101 of semiconductor device 100 are formed along the boundary line 100a, while the output terminals 102 are formed along the boundary line 100b on the other side of the boundary line 100a.

Each of the input terminals 101 of semiconductor device 100 is of square shape, as shown in FIG. 1.

Each of the output terminals 102 of the semiconductor device 100 is in the shape of a rectangle with its shorter side facing the input terminals 101.

A spacing of the output terminals 102 is finer than a spacing of the plurality of input terminals 101.

As shown in FIG. 2, the test probe 1 includes a silicon substrate 2 (substrate), an input projection portion 11, an output projection portion 21, a plurality of input wirings 12, and a plurality of output wirings 22.

The input projection portion 11 and the output projection portion 21 are formed on first surface 2a of the silicon substrate 2 so as to correspond to the array direction of the plurality of input terminals 101 and the array direction of the plurality of output terminals 102 of the semiconductor device 100.

The material of input projection portion 11 and output projection portion 21 is resin.

During the test, each of the input wirings 12 is in contact with each of the input terminals 101 of the semiconductor device 100, while each of the output terminals 102 is in contact with each of the output wirings 22 of the semiconductor device 100.

Each of the plurality of input wirings 12 includes and includes an input contacting portion 13 and an input conductive portion 14.

Each of the plurality of output wirings 22 includes and includes an output contacting portion 23 and an output conductive portion 24.

The input contacting portions 13 are formed on the surface of the input projection portion 11 on the silicon substrate 2.

The output contacting portions 23 are formed on the surface of the output projection portion 21 on the silicon substrate 2.

The input conductive portions 14 are formed an area different from an area in which the input projection portion 11 is formed on first surface 2a of the silicon substrate 2.

The output conductive portions 24 are formed on an area other than an area in which the output projection portion 21 is formed on first surface 2a of the silicon substrate 2.

As shown in FIG. 2 and FIG. 3, the input contacting portions 13 of the test probe 1 are formed side by side in direction of an array of the input terminals 101 of the semiconductor device 100.

The output contacting portions 23 of the test probe 1 are formed side by side in direction of an array of the output terminals 102 of the semiconductor device 100.

Each of the input contacting portions 12 is formed to correspond to each of the input terminals 101.

Each of the output contacting portions 23 is formed to correspond to each of the terminals 102.

That is, a spacing of each of the input contacting portions 13 (distance, pitch of input contacting portions 13 of test probe 1) corresponds to a spacing (pitch) of each of the input terminals 101 of the semiconductor device 100.

A spacing of each of the output contacting portions 23 (distance, pitch of output contacting portions 23 of test probe 1) corresponds to a spacing (pitch) of each of the output terminals 102 of the semiconductor device 100.

The input conductive portions 14 are formed to correspond to each of the input contacting portions 13.

Each of the input conductive portions 14 is connected to each of the input contacting portions 13, and is formed to extend along the direction of the X-axis and side by side in the direction of the Y-axis in an area other than the area on which the input projection portion 11 is formed, on the surface oxidation film 31 formed on the silicon substrate 2.

The output conductive portions 24 are formed to correspond to each of the output contacting portions 23.

Each of the output conductive portions 24 is connected to each of the output contacting portions 23, and is formed to extend along the direction of the X-axis and side by side in the direction of the Y-axis, in an area other than the area on which the output projection portion 21 is formed, on the surface oxidation film 31 formed on the silicon substrate 2.

More specifically, each of the input conductive portions 14 is formed such that the pitch increases along the positive X-axis direction, as shown in FIG. 2.

The pitch between each of the input contacting portions 13 formed on the input projection portion 11 may be for example 100 µm.

The pitch between each of the input conductive portions 14 formed on the first surface 2a of a side of an end surface 2c of the silicon substrate 2 is greater than 100 µm.

The pitch between each of the output conductive portions 24 also similar to the input conductive portions 14, widens along the negative X-axis direction.

The pitch between each of the output contacting portions 23 formed on the output projection portion 21 may be for example 10 to 50 µm.

The pitch between each of the output conductive portions 24 formed on the first surface 2a of a side of an end face 2d on the opposite side of the end surface 2c of the silicon substrate 2 is greater than 50 µm.

The materials constituting input contacting portions 13, output contacting portions 23, input conductive portions 14, output conductive portions 24 may be used gold (Au), copper (Cu), silver (Ag), titanium (Ti), tungsten (W), titanium-tungsten (TiW), titanium nitride (TiN), nickel (Ni), nickel-vanadium (NiV), chromium (Cr), aluminum (Al), palladium (Pd), and so on.

The structure of the input wiring 12 and the output wiring 22 may be a single layer structure consisting of the materials mentioned above, or may be a laminated structure consisting of layers of a plurality of materials.

As shown in PIG. 2 and FIG. 3, the input projection portion 11 and the output projection portion 21 are formed substantially at the center of the silicon substrate 2 and extend in the Y-axis direction.

The input projection portion 11 supports each of the plurality of input contacting portions 13.

The output projection portion 21 supports each of the plurality of output contacting portions 23.

If the input projection portion 11 and the output projection portion 21 are viewed from the direction of the arrays (Y-direction) of the input contacting portions 13 and the output contacting portions 23, they are in the shape of a circular arc in the cross-sectional view and project in a direction perpendicular to the silicon substrate 2, that is in the positive Z direction.

Accordingly, the surfaces of input projection portion 11 and output projection portion 21 are curved surfaces.

As shown in FIG. 4, areas other than an area on which the output contacting portions 23 are formed, are depressed.

A depression 3D is formed between each of the output contacting portions 23.

The cross-sectional view of the output projection portion 21 is shown in FIG. 4, but the depression 3D is formed similarly even in the cross-sectional view of the input projection portion 11, and areas other than an area on which the input contacting portions 13 are formed, are depressed.

The input projection portion 11 and the output projection portion 21 are made of resin (synthetic resin).

The material of the projection portion 11 and the output projection portion 21 may be a photosensitive resin.

The material of input projection portion 11 and the output projection portion 21 may be an insulating material such as polyamide resin, silicon modified polyamide resin, epoxy resin, silicon modified epoxy resin, acrylic resin, phenolic resin, benzocyclobutene (BCB), or polybenzoxazole (PBO).

As shown in FIG. 3, a surface oxidation film 31 is formed between the silicon substrate 2 and the input conductive portions 14, and between the silicon substrate 2 and the output conductive portions 24.

The surface oxidation film 31 is formed between the silicon substrate 2 and the input projection portion 11, and between the silicon substrate 2 and the output projection portion 21.

A rear face oxidation film 32 is also formed on the second surface 2b on the opposite side of the first surface 2a in the silicon substrate 2.

A protective insulating layer 33 (insulating layer) is formed in areas other than an area on which the input projection portion 11 and the output projection portion 21 are formed.

The protective insulating layer 33 covers the input conductive portions 14 and the output conductive portions 24.

The input conductive portions 14 and the output conductive portions 24 are protected by the protective insulating layer 33.

The material of the protective insulating layer 33 may be used a photosensitive resin.

As shown in FIG. 3, input through holes 51 and output through holes 52 are formed in the silicon substrate 2 passing from the first surface 2a to the second surface 2b of the silicon substrate 2.

A plurality of input through holes 51 are formed to correspond to the number of the plurality of input conductive portions 14.

A plurality of output through holes 52 are formed to correspond to the number of the plurality of output conductive portions 24.

An input through electrode 53 (input continuity portion) which is electrically connected to the input conductive portion 14, is formed inside each of the input through holes 51.

An output through electrode 54 (output continuity portion) which is electrically connected to the output conductive portion 24 is formed inside each of the plurality of output through holes 52.

Furthermore, as shown in FIG. 1 and FIG. 3, each of the plurality of input through electrodes 53 is electrically connected to each of the plurality of input rear face conductive portions 55 (input connecting conductive portions) formed on the second surface 2b of silicon substrate 2.

Each of the plurality of output through electrodes 54 is electrically connected to each of the plurality of output rear face conductive portions 56 (output connecting conductive portions) formed on the second surface 2b of silicon substrate 2.

Next, the testing method for testing semiconductor device 100 using test probe 1 of the first embodiment described above.

First, the test probe 1 is set in the semiconductor-testing device (not shown).

Next, the input rear face conductive portions 55 and the output rear face conductive portions 56 of the test probe 1, are connected to the wirings of the semiconductor testing device.

Subsequently, the input terminals 101 of semiconductor device 100 and the input contacting portions 13 of test probe 1 are positioned and aligned, and the output terminals 102 of semiconductor device 100 and the output contacting portions 23 of the test probe 1.

As shown in FIG. 2, each of the input contacting portions 13 of the test probe 1 are brought into contact with each of the input terminals 101 of the semiconductor device 100, and each of the output contacting portions 23 of the test probe 1 are brought into contact with each of the output terminals 102 of the semiconductor device 100.

The silicon substrate 2 of the test probe 1 is pressed down on the semiconductor device 100.

As a result, each of the input terminals 101 is firm contact with each of the input contacting portions 13, and each of the output terminals 102 is firm contact with each of the output contacting portions 23, so that electrical connections are obtained.

According to the test probe 1 of semiconductor device 100 of the first embodiment, since input wirings 12 and output wirings 22 are formed on the silicon substrate 2, very fine input wirings 12 and output wirings 22 can be obtained by the application of semiconductor device manufacturing technologies.

Accordingly, even if wirings of the semiconductor device 100 is finer, and the pitch of the input terminals 101 and output terminals 102 is finer, it is possible to realize the test probe 1 having very fine input contacting portions 13 and output contacting portions 23 and corresponding to the finer pitch of the input terminals 101 and the finer pitch of the output terminals 102.

The input contacting portions 13 and the output contacting portions 23 in direct contact with the input terminals 101 and the output terminals 102 of the semiconductor device 100 are formed on the input projection portion 11 and the output pump 21 that are made of resin.

Therefore, when the input contacting portions 13 and the output contacting portions 23 are in contact with the input terminals 101 and output terminals 102 of the semiconductor device 100, because of the elastic action of the input projection portion 11 and the output projection portion 21, satisfactory contact with the input terminals 101 and output terminals 102 of the semiconductor device 100 can be realized.

Since the input contacting portions 13 and the output contacting portions 23 are arranged side by side in the Y-axis direction to correspond to the input terminals 101 and the output terminals 102 of the semiconductor device 100, each of the input contacting portions 13 is brought into contact with each of the input terminals 101, and each of the output contacting portions 23 is brought into contact with each of the output terminals 102, enabling satisfactory testing of the semiconductor device 100 by the test probe 1.

By using a soft material such as silver (Ag) as the material of the input contacting portions 13 and the output contacting portions 23 (input wiring 12 and output wiring 22), it is possible to obtain the firm contact with the input terminals 101 and the output terminals 102 of the semiconductor device 100.

Furthermore, since the input projection portion 11 and the output projection portion 21 are formed so as to extend in the Y-axis direction along the array direction of the input contacting portions 13 and the output contacting portions 23, the input contacting portions 13 can be formed on the input projection portion 11 and the output contacting portions 23 can be formed on the output projection portion 21.

Accordingly, the variation in position in the vertical direction of the input contacting portions 13 and the output contacting portions 23 can be inhibited.

Moreover, since the input projection portion 11 and the output projection portion 21 are formed in the shape of a circular arc in the cross-sectional view, it is possible to obtain the firm contact of the input contacting portions 13 and the output contacting portions 23 with the input terminals 101 and the output terminals 102 of the semiconductor device 100.

Furthermore, when the input contacting portions 13 are formed on the surface of the input projection portion 11, or when the output contacting portions 23 are formed on the surface of the output projection portion 21, the input contacting portions 13 can be brought into firm contact on the surface of the input projection portion 11, and the output contacting portions 23 can be brought into firm contact on the surface of the output projection portion 21.

Since the depression 3D is formed between each of the input contacting portions 13 on the surface of the input projection portion 11, when the input contacting portions 13 are in contact with the input terminals 101 of the semiconductor device 100, the input projection portion 11 which is formed as the base of the input contacting portions 13, deflects and deforms.

Since the depression 3D is formed between each of the plurality of the output contacting portions 23 on the surface of the output projection portion 21, when the output contacting portions 23 are in contact with the output terminals 102 of the semiconductor device 102, the output projection portion 21 which is formed as the base of the output contacting portions 23, deflects and deforms.

Accordingly, because of the deflection and deformation of the input projection portion 11 and the output projection portion 21, it is possible to obtain to be the input contacting portions 13 firm contact with the input terminals 101, and it is possible to obtain to be the output contacting portions 23 firm contact with the output terminals 102.

It is preferable that the depth of the depression 3D of the input projection portion 11 and the output projection portion 21 be greater than 5 µm.

Such a depth enables adequate deflection and deformation of the input projection portion 11 and the output projection portion 21 to be obtained.

Furthermore, the input rear face conductive portions 55 for input of signals such as test signal for testing the semiconductor device, and the output rear face conductive portions 56 for extracting signals such as test signal, are formed on the second surface 2b of the silicon substrate 2.

Each of the input contacting portions 13 is electrically connected to each of the input rear face conductive portions 55 formed on the second surface 2b of the silicon substrate 2 through each of the input through electrodes 53.

Each of the plurality of output contacting portions 23 is electrically connected to each of the output rear face conductive portions 56 formed on the second surface 2b of the silicon substrate 2 through each of the output through electrodes 54.

Consequently, when testing semiconductor device 100 by facing the input projection portion 11 toward the input terminals 101 of the semiconductor device 100, signals such as a test signal can be input to the input terminals 101 of semiconductor device 100 through the input rear face conductive portions 55 from a surface (second surface 2b) differing from the surface (first surface 2a) facing the input terminals 101 of semiconductor device 100.

When testing semiconductor device 100 by facing the output projection portion 21 toward the output terminals 102 of the semiconductor device 100, signals such as a test signal can be extracted from the output terminals 102 of semiconductor device 100 through the output rear face conductive portions 56 from a surface (second surface 2b) differing from the surface (first surface 2a) facing the output terminals 102 of semiconductor device 100.

Compared to the case of which the input rear face conductive portions 55 and the output rear face conductive portions 56 are formed on the first surface 2a of silicon substrate 2, input and extraction of signals such as test signal are facilitated, and semiconductor device 100 can be easily tested.

The work of installing the test probe on the testing unit also becomes easier.

Since the protective insulating layer 33 covers the input conductive portions 14 and output conductive portions 24 on the first surface 2a of the silicon substrate 2, it is possible to prevent short-circuitting between the semiconductor device 100 and the input conductive portions 14 or the output conductive portions 24, or short-circuitting between the input conductive portions 14 and the output conductive portions 24.

Method of manufacture for the test probe

Next, the manufacturing method for the test probe 1 is described here, referring to FIGS. 5A to 6D.

The manufacturing method for the test probe 1, includes forming a plurality of probe formation areas constituting test probes 1 on the base substrate such as silicon wafer, cutting the base substrate at each the probe formation area, and manufacturing a plurality of individual test probes 1.

Accordingly, the test probes 1 are formed in one batch simultaneously on the base substrate.

The manufacturing method for the test probe is described below.

A plurality of silicon substrates 2 are obtained by cutting silicon wafer 200, and a plurality of test probes 1 are manufactured.

Therefore, the same reference symbol is affixed on the same parts of members constituting the above-mentioned test probe 1, in the silicon wafer 200.

Firstly as shown in FIG. 5A, the silicon wafer 200 which is the base substrate, is kept ready.

Next, the input through holes 51 and the output through holes 52 are formed, passing through from the first surface 2a to the second surface 2b of the silicon wafer 200.

These input through holes 51 and output through holes 52 are formed by laser processing , dry etching method, wet etching method in addition to mechanical processing, or by a combination of the methods mentioned here.

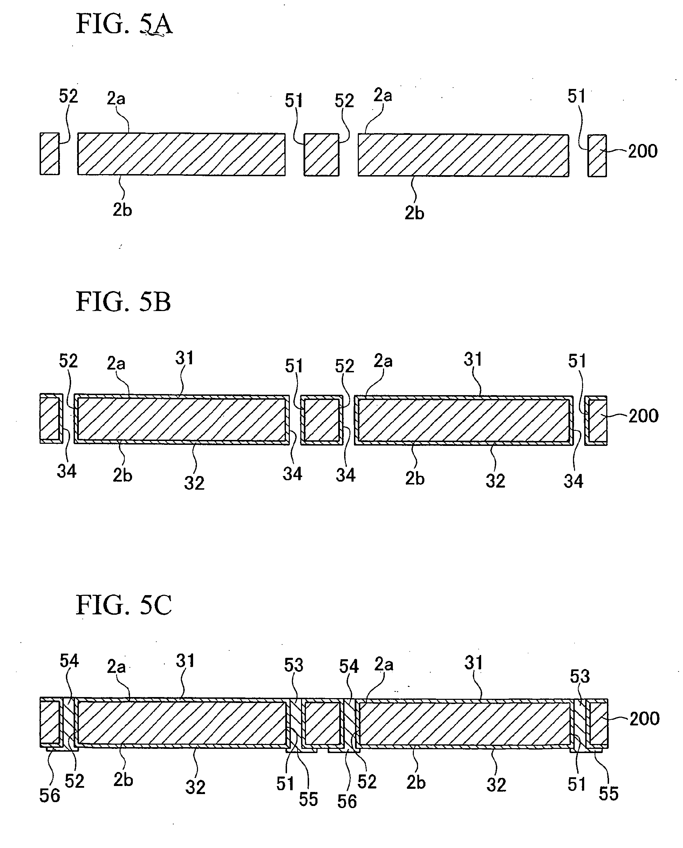

Next, as shown in FIG. 5B, surface oxidation film 31 is formed on the first surface 2a of the silicon wafer 200 and rear face oxidation film 32 is formed on the second surface 2b by thermal oxidation of the silicon wafer 200, and insulating layer 34 is formed on the inner walls of the input through holes 51 and output through holes 52.

As a result, all the exposed surfaces of the silicon wafer 200 are electrically insulated.

Next, the inner sides of the input through holes 51 and the output through holes 52 are electrochemically plated using the electrochemical plating method (ECP), and conductive materials are formed to fill the input through holes 51 and the output through holes 52.

The conductive materials are the materials of input through electrodes 53 and output through electrodes 54.

A material such as copper (Cu) can be used as the material of the input through electrodes 53 and the output through electrodes 54.

Consequently, copper (Cu) is filled in the input through holes 51 and the output through holes 52.

As a result, as shown in FIG. 5C, the input through electrodes 53 and the output through electrodes 54 are formed, and simultaneously, the input rear face conductive portions 55 electrically connected to input through electrodes 53 are formed and the output rear face conductive portions 56 electrically connected to output through electrodes 54 are formed in the second surface 2b of the silicon wafer 200.

The method of formation of the input through electrodes 53 and the output through electrodes 54 is not limited to the method described above, conductive paste, molten metal, or metal wiring may also be filled.

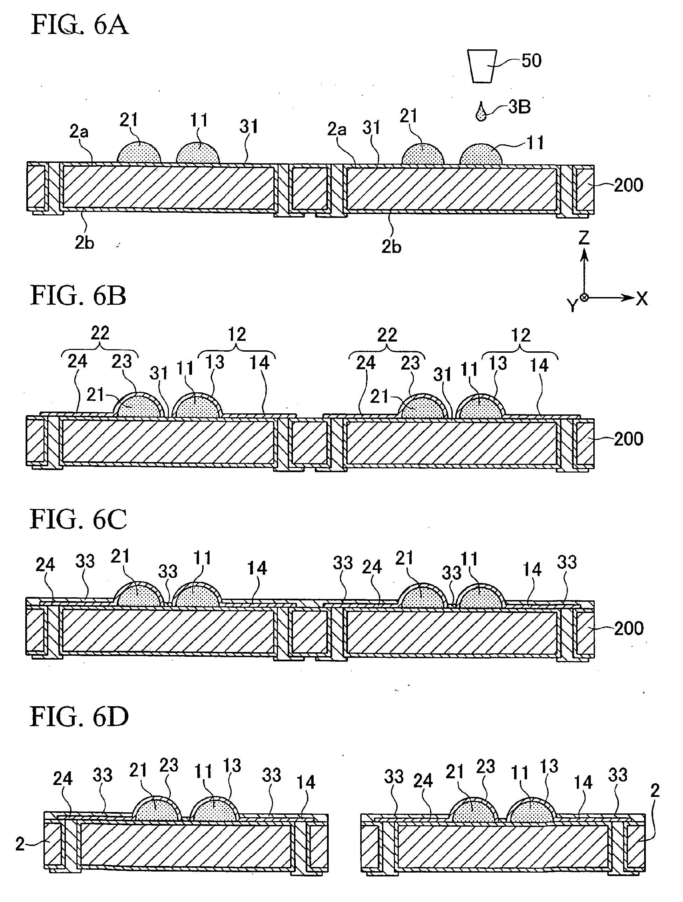

Next, as shown in FIG. 6A, resin is arranged to form the input projection portion 11 and the output projection portion 21 in predetermined area on the surface oxidation film 31.

The input projection portion 11 and the output projection portion 21 extend in a predetermined direction (Y-axis direction) on the silicon wafer 200.

The cross-sectional shape of the input projection portion 11 and the cross-sectional shape of the output projection portion 21 are a circular arc when viewed from the Y-direction.

In this embodiment, the input projection portion 11 and the output projection portion 21 are formed by the liquid ejection method (inkjet method).

As shown in FIG. 6A, the droplets of a functional liquid 3B including resin are ejected from a droplet ejection head 50 (inkjet head) for forming the input projection portion 11 and the output projection portion 21 on the silicon wafer 200 (surface oxidation film 31) in the liquid ejection method.

As a result, the input projection portion 11 and the output projection portion 21, which are shaped in the form of a circular arc in the cross-sectional view, are formed on the silicon wafer 200 and protrude from the surface of the silicon wafer 200 (height from the surface oxidation film 31 is between 5 to 30 µm).

By using the liquid ejection method, and forming of the input projection portion 11 and the output projection portion 21, input projection portion 11 and output projection portion 21 can be formed efficiently without unnecessary wastage of material.

Next, as shown in FIG. 6B, the input wirings 12 and the output wirings 22 including the input contacting portions 13, the output contacting portions 23, the input conductive portions 14 and the output conductive portions 24 are formed on the input projection portion 11, on the output projection portion 21, and on the surface oxidation film 31.

The input wirings 12 and the output wirings 22 can be formed using the sputtering method, the electroplating method, or the liquid ejection method (inkjet method).

In this embodiment, the input wirings 12 and the output wirings 22 are formed using the sputtering method.

First, metallic films such as TiW and Au films are formed (built up) on the silicon wafer 200 by the sputtering method.

Subsequently, resist film is patterned using known photolithographic methods and etching methods.

Then, metallic film is etched through the openings in the resist film.

Subsequently, the resist film is removed.

Accordingly, as shown in FIG. 6B, the input contacting portions 13 corresponding to input terminals 101 of semiconductor device 100 are formed on the input projection portion 11 as an array in the longitudinal direction of the input projection portion 11.

Moreover, the output contacting portions 23 corresponding to output terminals 102 of semiconductor device 100 are formed on the output projection portion 21 as an array in the longitudinal direction of the output projection portion 21.

Here, the surface of the input projection portion 11 between each of the plurality of input contacting portions 13, is exposed.

Also, the surface of the output projection portion 21 between each of the plurality of output contacting portions 23, is exposed.

Furthermore, in the area other than the area on which the input projection portion 11 and are the output projection portion 21 are formed on the silicon wafer 200, the input conductive portions 14 electrically connected to the input contacting portions 13 and the output conductive portions 24 electrically connected to the output contacting portions 23, are formed.

Next, by implementing O₂-plasma processing on the input projection portion 11 and the output projection portion 21, areas (exposed areas) other than the areas on which the input contacting portions 13 and the output contacting portions 23 are formed, are selectively half-etched by masking of the input contacting portions 13 and the output contacting portions 23.

As a result, depressions 3D are formed between each of the input contacting portions 13 and between each of the output contacting portions 23, as shown in FIG. 4.

Next, as shown in FIG. 6C, protective insulating layer 33 is formed to cover the input conductive portions 14 and the output conductive portions 24.

As shown in FIG. 6D, the silicon wafer 200 is diced (cut) at each of the probe formation areas constituting the test probe 1.

In this manner, the test probes 1 are formed at the same time on the silicon wafer 200.

By cutting this silicon wafer 200 at each of the probe formation areas, a plurality of individual test probes 1 can be obtained, as shown in FIG. 3.

In this manner, a plurality of test probes 1 can be manufactured with efficiency, and test probe 1 can be manufactured at low cost.

The scope of the skill of-the invention is not limited to the embodiment mentioned above, and various changes may be effected to the invention without departing from the spirit and scope of the invention.

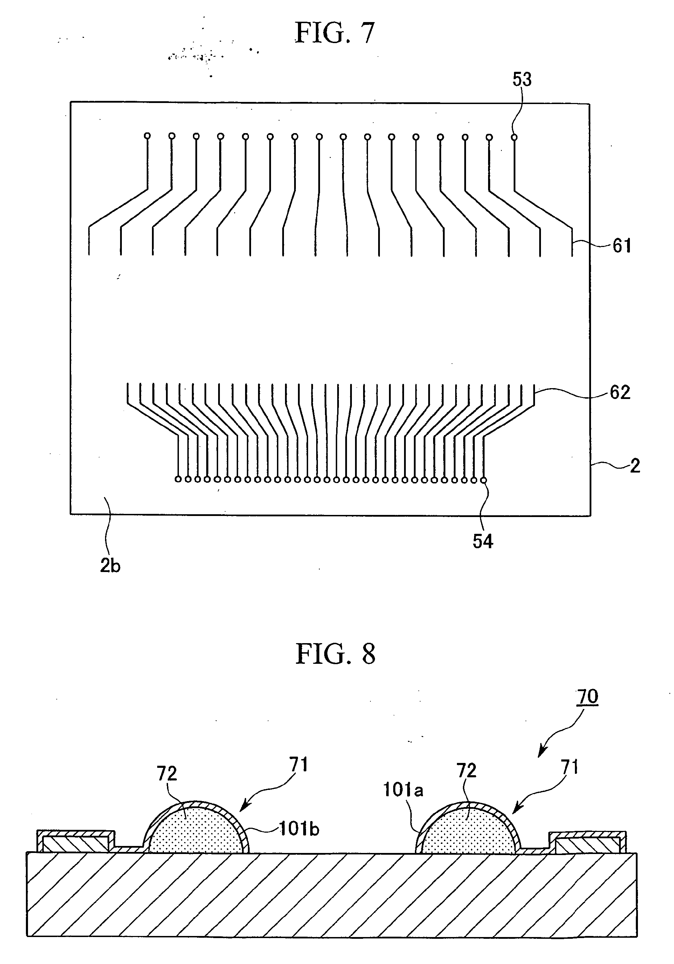

For example, instead of the input rear face conductive portions 55 electrically connected to the input through electrodes 53, input connecting conductive portions 61 may be used as shown in FIG. 7.

The spacing of each of the input connecting conductive portions 61 may be widened toward the inside of the silicon substrate 2.

Here, the spacing of each of the input connecting conductive portions 61 is greater than the spacing of each of the input conductive portions 14.

For example, instead of the output rear face current-carrying parts 56 electrically connected to the output through electrodes 54, output connecting conductive portions 62 may be used as shown in FIG. 7.

The spacing of each of the output connecting conductive portions 62 may be widened toward the inside of the silicon substrate 2.

Here, the spacing of each of the output connecting conductive portions 62 is greater than the spacing of each of the output conductive portions 24.

When testing the semiconductor device 100 with this configuration, short-circuitting between the input connecting conductive portions 61 each other or short-circuitting between the output connecting conductive portions 62 each other can be prevented, and the semiconductor device 100 can be correctly tested.

Furthermore, the spacing of each of the input connecting conductive portions 61 toward the inside surface of the silicon substrate 2, and the spacing of each of the output connecting conductive portions 62 can be widened such that even if the pitch of the terminals of the semiconductor device 100 is fine, test probe 1 compatible with the finer pitch can be realized.

A test probe that enables a more compact silicon substrate 2 can be achieved.

The method of forming the input projection portion 11 and the output projection portion 21 is not limited to only the liquid ejection method, but they may also be formed by the photolithographic method.

In this method, the input projection portion 11 and the output projection portion 21 are formed using photosensitive resin, exposed, and according to the conditions of development and cure, input projection portion 11 and output projection portion 21 of circular arc shape in cross-sectional view can be easily formed with high-precision.

Moreover, the input wirings 12 and the output wirings 22 were formed by the sputtering method, but their formation is not limited to this method only, and they may be formed by the electroplating method for example.

In this method, after sputtering TiW and Au on the surface oxidation film 31, resist is applied and this resist is patterned to form the resist pattern for forming the input conductive portions 21 and the output conductive portions 22 by the electroplating method.

Next, Au electroplating is implemented, Au (gold) is filled in the plated resist pattern, and the input wirings 12 and the output wirings 22 are formed.

Subsequently, the resist is peeled off, and TiW etching and Au etching are performed.

The input wirings 12 and the output wirings 22 may also be formed by the liquid ejection method (inkjet method).

In this method, after drawing the input wirings 12 and output wirings 22 using Ag (silver) ink, baking the input wirings 12 and output wirings 22, and film is formed by electroless Ni/Au plating.

Moreover, the input through holes 51 and the output through holes 52 were formed in the silicon wafer 200 as the manufacturing method for the test probe 1, but the method is not limited to this process only.

For example, after forming the protective insulating layer to cover the input conductive portions 14 and the output conductive portions 24, the input through holes 51 and the output through holes 52 may be formed, conductive material may be filled in these through holes 51 and 52, and the input rear face conductive portions 55 and the output rear face conductive portions 56 may be formed.

Moreover, as shown in FIG. 1, the test probe 1 mentioned above is preferred for performing tests on semiconductor wafer on which a plurality of the probe formation areas are formed.

Metallic projection portions, such as Au projection portions, Ni projection portions, and soldered projection portions are preferred for the input terminals 101 and the output terminals 102 of the semiconductor device 100 to be tested.

When the input contacting portions 13 and the output contacting portions 23 are in contact with the input terminals 101 and the output terminals 102 of the semiconductor device 100 respectively, the variation in the height of the metallic projection portions can be absorbed by the elastic action of the input projection portion 11 and the output projection portion 21.

Consequently, the input terminals 101 can be in firm contact with the input contacting portions 13, and the output terminals 102 can be in firm contact with the output contacting portions 23.

Furthermore, instead of input terminals 101 and output terminals 102 of semiconductor device 100, the test probe 1 is also preferred for testing semiconductor device 70 which has bumps 71 including resin cores 72 are formed as shown in FIG. 8. [00255] That is, as mentioned above, when the input contacting portions 13 are in contact with the bumps 71, the elasticity of the bumps 71 is absorbed by the elastic action of the input projection portion 11 made of resin, and thus the damage to terminals 101a formed on the surface of the bumps 71 can be prevented. [00256] In addition, when the output contacting portions 23 are in contact with the bumps 71, the elasticity of projection portion is absorbed by the elastic action of the output projection portion 21 made of resin, and thus the damage to terminals 101b formed on the surface of the projection portion 71 can be prevented.

## Claims

1. A test probe for testing a semiconductor device (100) having a plurality of input terminals (101) and a plurality of output terminals (102), comprising:
a substrate (2) having a first surface (2a) and a second surface (2b);
an input projection portion (11), made of resin, formed on the first surface (2a) of the substrate (2), and corresponding to an array of the input terminals (101) of the semiconductor device (100);
an output projection portion (21), made of resin, formed on the first surface (2a) of the substrate (2), and corresponding to an array of the output terminals (102) of the semiconductor device (100);
a plurality of input contacting portions (13), each of which is in contact with each of the input terminals (101) of the semiconductor device (100) and is formed on the input projection portion (11);
a plurality of output contacting portions (23), each of which is in contact with each of the output terminals (102) of the semiconductor device (100) and is formed on the output projection portion (21);
a plurality of input conductive portions (14) formed in an area other than an area on which the input projection portion (11) is formed on the first surface (2a) of the substrate (2), each of which is electrically connected to each of the input contacting portions (13); and
a plurality of output conductive portions (24) formed in an area other than an area on which the output projection portion (21) is formed on the first surface (2a) of the substrate (2), each of which is electrically connected to each of the output contacting portions (23).

2. The test probe according to claim 1, wherein, the input contacting portions (13) are formed side by side, corresponding to a direction of the array of the input terminals (101) of the semiconductor device (100), the output contacting portions (23) are formed side by side, corresponding to a direction of the array of the output terminals (102) of the semiconductor device (100), each of the input conductive portions (14) is formed to correspond to each of the input contacting portions (13), and each of the output conductive portions (24) is formed to correspond to each of the output contacting portions (23).

3. The test probe according to one of claims 1 and 2, wherein, the input projection portion (11) extends in the direction of an array of the input contacting portions (13), and the output projection portion (21) extends in the direction of an array of the output contacting portions (23).

4. The test probe according to any one of claims 1 to 3, wherein, a cross-section of the input projection portion (11) viewed from the direction of the array of the input contacting portions (13) is in the shape of a circular arc projecting from the first surface (2a) of the substrate (2), and a cross-section of the output projection portion (21) viewed from the direction of the array of the output contacting portions (23) is in the shape of a circular arc projecting from the first surface (2a) of the substrate (2).

5. The test probe according to any one of claims 1 to 4, further comprising:
a plurality of depressions (3D) formed on the surface of the input projection portion (11) and on the surface of the output projection portion (21), each of which is formed in an area other than an area on which each of the input contacting portions (13), and in an area other than an area on which each of the output contacting portions (23) is formed.

6. The test probe according to any one of claims 1 to 5, further comprising:
a plurality of input continuity portions (53), each of which passes through the substrate (2) from the first surface (2a) to the second surface (2b) and is electrically connected to each of the input conductive portions (14);
a plurality of output continuity portions (54), each of which passes through the substrate (2) from the first surface (2a) to the second surface (2b) and is electrically connected to each of the output conductive portions (24);
a plurality of input connecting conductive portions (55), each of which is electrically connected to each of the input continuity portions (53) and is formed on the second surface (2b) of the substrate (2); and
a plurality of output connecting conductive portions (56), each of which is electrically connected to each of the output continuity portions (54) and is formed on the second surface (2b) of the substrate (2).

7. The test probe according to claim 6, wherein, a spacing between each of the adjacent input connecting conductive portions (55) is larger than a spacing between each of the adjacent input conductive portions (14), and a spacing between each of the adjacent output connecting conductive portions (56) is larger than a spacing between each of the adjacent output conductive portions (24).

8. The test probe according to any one of claims 1 to 7, further comprising:
an insulating layer (33) covering the input conductive portions (14) and the output conductive portions (24).

9. A manufacturing method for a test probe testing a semiconductor device (100) having a plurality of input terminals (101) and a plurality of output terminals (102), comprising:
preparing a substrate (2);
forming input projection portion (11) made of resin on the substrate (2) and corresponding to an array of the input terminals (101) of the semiconductor device (100);
forming output projection portion (21) made of resin on the substrate (2) and corresponding to an array of the output terminals (102) of the semiconductor device (100);
forming a plurality of input contacting portions (13) on the input projection portion (11);
forming a plurality of output contacting portions (23) on the output projection portion (21);
forming on the substrate (2) a plurality of input conductive portions (14) in an area other than an area on which the input projection portion (11) is formed; and
forming on the substrate (2) a plurality of output conductive portions (24) in an area other than an area on which the output projection portion (21) is formed.

10. The manufacturing method for a test probe according to claim 9, further comprising:
forming a plurality of depressions (3D), each of which is formed in an area other than an area on which each of the input contacting portions (13) is formed on the surface of the input projection portion (11) by half-etching; and
forming a plurality of depressions (3D), each of which is formed in an area other than an area on which each of the output contacting portions (23) is formed on the surface of the output projection portion (21) by half-etching, wherein,
the input contacting portions (13) are formed side by side to correspond to the direction of the array of the input terminals (101) of the semiconductor device (100), the output contacting portions (23) are formed side by side to correspond to the direction of the array of the output terminals (102) of the semiconductor device (100).

11. The manufacturing method for a test probe according to one of claims 9 and 10, wherein, the input projection portion (11) and the output projection portion (21) are made of photosensitive resin.

12. The manufacturing method for a test probe according to any one of claims 9 to 11, wherein, the input projection portion (11) and the output projection portion (21) are formed on the substrate (2) by ejecting functional liquid including resinous material on the substrate (2) by a liquid drop method.

13. The manufacturing method for a test probe according to any one of claims 9 to 12, wherein, the input contacting portions (13), the input conductive portions (14), the output contacting portions (23), and the output conductive portions (24), are formed by a sputtering method or a plating method.

14. The manufacturing method for a test probe according to any one of claims 9 to . 13, wherein, the input contacting portions (13), the input conductive portions (14), the output contacting portions (23), and the output conductive portions (24), are formed on the substrate (2) by a liquid drop method.

15. The manufacturing method for a test probe according to any one of claims 9 to 14, further comprising:
preparing a base substrate (200);
forming a plurality of probe formation areas, each of which corresponds to each of the test probes (1) on the base substrate (200);
cutting the base substrate (200) at each the probe formation areas; and
obtaining a plurality of individual test probes (1).
